# EUROPÄISCHE PATENTSCHRIFT

(11) **EP 0 821 443 B1**
(45) Veröffentlichungstag und Bekanntmachung des Hinweises auf die Patenterteilung: **31.07.2002**
(21) Anmeldenummer: 97111576.1
(22) Anmeldetag: 09.07.1997
(51) Int. Cl.: H01R 13/639, G01R 31/04

(54) **Vorrichtung zum Prüfen eines mit Kabeln versehenen Steckers**
Device for checking a plug-type connector provided with cables
Dispositif d'essai pour un connecteur à fiche pourvu de câbles

(30) Priorität: 26.07.1996 DE 29612973 U
(43) Veröffentlichungstag der Anmeldung: 28.01.1998
(60) Teilanmeldung: 00110759.8
(73) Patentinhaber: TSK Prüfsysteme GmbH, 32457 Porta Westfalica (DE)
(72) Erfinder: Mohme, Heinrich, 33602 Vlotho (DE); Günther, Wolfgang, 31707 Heessen (DE); Benedix, Lutz, 31542 Bad Nenndorf (DE)
(74) Vertreter: Stracke, Alexander, Dipl.-Ing.

(56) Entgegenhaltungen:
- EP-A- 0 565 080
- DE-A- 4 204 283
- DE-U- 9 210 417
- GB-A- 2 200 503

## Beschreibung

Die vorliegende Erfindung betroifft eine Vorrichtung zum Prüfen eines mit Kabeln versehenen Steckers gemäß dem Oberbegriff des Anspruchs 1.

Eine derartige Vorrichtung ist aus der DE 92 10 417 U1 sowie der GB 2 200 503 A bekannt.

Die darin gezeigte und beschriebene Vorrichtung hat sich prinzipiell bewährt.

Allerdings ist die Funktionsfähigkeit dann etwas eingeschränkt, wenn mehrere Vorrichtungen auf einer Arbeitsplatte vorgesehen sind.

In diesem Fall ist üblicherweise nur eine zentrale Entriegelung aller Vorrichtungen möglich, es sei denn, jede einzelne Vorrichtung ist mit einem zusätzlichen Steuerorgan ausgestattet, das eine separate Entriegelung jeder einzelnen Vorrichtung ermöglicht.

Naturgemäß ist dies mit einem erheblichen Aufwand verbunden, der die Herstellungskosten jeder Vorrichtung ungünstig beeinflußt.

Der vorliegenden Erfindung liegt daher die Aufgabe zugrunde, eine Vorrichtung der gattungsgemäßen Art so zu gestalten, daß mit konstruktiv einfachen Mitteln die Funktionsfähigkeit dadurch verbessert wird, daß jede einzelne Vorrichtung von einer Vielzahl in einem Arbeitsbereich angeordneten und zentral betätigbaren Vorrichtungen entriegelbar ist.

Diese Aufgabe wird durch eine Vorrichtung gelöst, die die Merkmale des Anspruches 1 aufweist.

Durch diese konstruktive Ausgestaltung der Vorrichtung besteht nun die Möglichkeit, ohne steuertechnischen Aufwand eine separate Entriegelung jeder Vorrichtung, die rein mechanisch erfolgt, vorzunehmen.

Ein besonderer Vorteil der Vorrichtung nach Anspruch 1 besteht darin, daß mittels einer solchen Vorrichtung mehrere Vorrichtungen gleichzeitig mechanisch entriegelt werden können, wobei diese Vorrichtungen keinen zusätzlichen Taster benötigen.

Dabei können beispielsweise zwei Vorrichtungen zum Verriegeln vorgesehen sein, von denen jeweils eine in den sich gegenüber liegenden Seitenbereichen einer Stekkeraufnahme angeordnet sind.

Die Arretierung kann sowohl fest als auch lösbar mit dem Aufnahmeteil verbunden sein. Letzteres ist beispielsweise aus der DE 42 04 283 bekannt.

Vorteilhafte Ausgestaltungen der Erfindung sind in den Unteransprüchen gekennzeichnet.

Ausführungsbeispiele der Erfindung werden nachfolgend anhand der beigefügten Zeichnungen beschrieben.

Es zeigen:

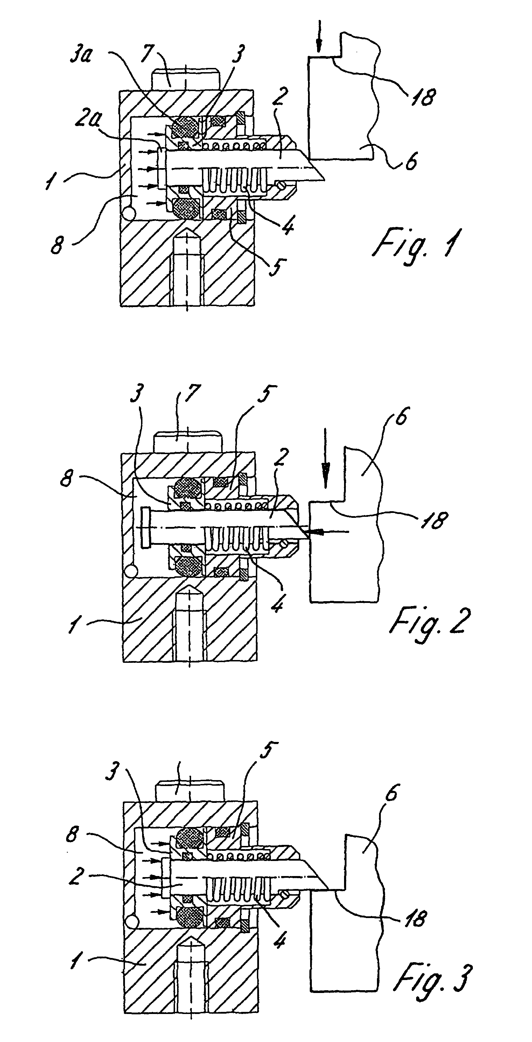

- Figuren 1-4: ein Ausführungsbeispiel der Vorrichtung nach Anspruch 1 in unterschiedlichen Betriebsstellungen jeweils in einer geschnittenen Seitenansicht.

Das in den Figuren 1-4 gezeigte Ausführungsbeispiel der Erfindung besteht im wesentlichen aus einem Gehäuse 1, das eine mit Druckluft beaufschlagte Kammer 8 aufweist, die an einer Seite durch eine Führungsbuchse 5 verschlossen ist.

In dieser Führungsbuchse 5 ist ein als Kolben 2 ausgebildeter Arretierungsstift hin und her bewegbar geführt, der einseitig mit einem Druckmedium, im vorliegenden Ausführungsbeispiel mit Druckluft, beaufschlagbar ist.

Die Druckrichtung wird durch die dargestellten Pfeile erkennbar.

Auf dem Kolben 2 ist eine Druckfeder 4 geführt, die sich einerseits am Grund einer Ausnehmung der Führungsbuchse 5 und andererseits an einem Druckring 3 abstützt, in dem der Kolben 2 gleitbar geführt ist.

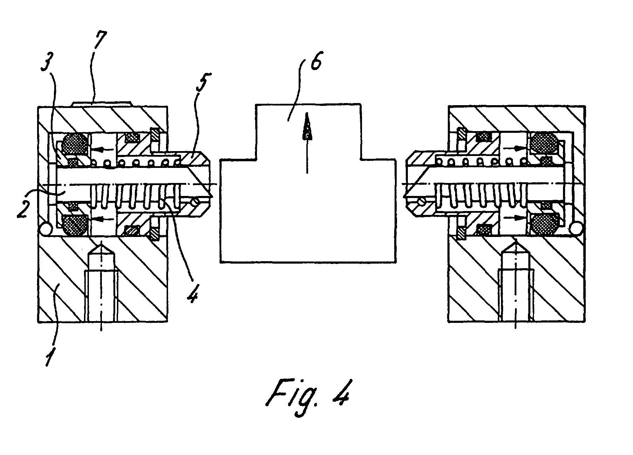

Dabei wird die der Druckfeder 4 abgewandte Seite des Druckringes 3 in Gebrauchsstellung des Kolbens 2 gleichfalls mit Druckluft beaufschlagt. Der Kolben 2 stützt sich mit einem angeformten Bündchen 2a bei den in den Figuren 1 und 3 gezeigten Stellungen an der mit Druckluft beaufschlagten Seite des Druckringes 3 ab.

Während die Führungsbuchse 5 als Gehäuseteil fest mit dem Gehäuse 1 im übrigen verbunden ist, ist der Druckring 3 in der Kammer 8 hin und her verschiebbar gelagert, wobei er einen Dichtring 3a trägt, der sich andererseits an der Kammerwandung abstützt. In den Figuren 1-4 sind unterschiedliche Arbeitsstellungen des Kolbens 2 gezeigt.

Dabei ist in der Figur 1 eine Position dargestellt, in der ein Stecker 6, der mittels des Kolbens, der die Funktion eines Arretierungsstiftes übernimmt, in einer nicht dargestellten Aufnahme arretiert wird, in diese Aufnahme eingeführt wird.

Hierbei ist die Kammer 8 mit Druckluft beaufschlagt, so daß der Druckring 3 an der Führungsbuchse 5 anliegt und der Kolben 2 mit seinem Bündchen 2a am Druckring 3.

Beim weiteren Einführen des Steckers 6 (Figur 2) wird der Kolben 2 gegen die Druckkraft der Druckluft in die Kammer 8 verschoben, wobei der Kolben 2 auf seiner dem Stecker 6 zugewandten Seite eine abgeschrägte Stimfläche aufweist, die ein leichtes Einführen des Steckers 6 bzw. ein leichtes Zurückdrücken des Kolbens 2 ermöglicht.

Dieses Zurückdrücken des Kolbens 2 erfolgt durch Anlage eines Vorsprunges 18 des Steckers 6.

Nach einem endgültigen Einführen des Steckers 6 in die Aufnahme, also nach Erreichen einer Endposition, schnappt der Kolben 2 in Richtung des Steckers 6 zurück und liegt an der entsprechenden Fläche des Vorsprungs 18 an, wodurch eine Sicherung des Steckers 6 gegen ein Herausdrücken durch nicht dargestellte Prüfnadeln erfolgt.

Da üblicherweise eine Vielzahl von derartigen Arretiervorrichtungen auf einer Arbeitsplatte angeordnet ist, um so entsprechend viele Stecker auf Verrastungsfehler gleichzeitig prüfen zu können, sind diese Arretiervorrichtungen an ein gemeinsames Ventil angeschlossen, so daß, wenn alle Arretierungen gleichzeitig gelöst werden sollen, lediglich die Betätigung des Ventils erforderlich ist.

Für den Fall, daß lediglich die Arretierung eines Steckers zu lösen ist, ist ein Taster 7 vorgesehen, der die Druckluftzufuhr zur Kammer 8 unterbricht, so daß der Druckring 3 und damit der Kolben 2 durch die Federkraft der Druckfeder 4 in die Kammer 8 zurückgedrückt wird. Hierdurch wird die Arretierung gelöst und der Stecker 6 kann entnommen werden.

Diese Position ist in der Figur 4 gezeigt.

Dabei ist auch erkennbar, daß zwei Arretiervorrichtungen vorgesehen sind, die sich gegenüberliegen und die insoweit miteinander gekoppelt sind, als lediglich ein Taster 7 vorgesehen ist, mit dem eine gemeinsame Druckluftzufuhr abstellbar ist.

Nach Loslassen des Tasters 7 und einer damit einhergehenden Freigabe der Druckluftzufuhr werden der Druckring 3 und der Kolben 2 wieder in die in der Figur 1 gezeigte Stellung verfahren.

Die Dimensionierung der Druckfeder 4 ist so bemessen, daß deren Federkraft kleiner ist als die auf den Druckring 3 einwirkende Druckkraft der Druckluft.

## Patentansprüche

1. Vorrichtung zum Prüfen eines mit Kabeln versehenen Steckers auf Verrastungs- und/oder Kontaktierungsfehler, mit einem Aufnahmeteil, das eine der Außenkontur eines bestimmten Steckers angepaßte Steckeraufnahme aufweist, in deren mindestens einem Seitenbereich eine Arretiereinrichtung vorgesehen ist, die einen durch Druck in Arretierstellung bringbaren Arretierungsstift aufweist, der als ein einseitig mit einem Druckmedium beaufschlagbarer Kolben (2) ausgebildet ist, **dadurch gekennzeichnet, daß** der Kolben (2) in einem ebenfalls mit dem Druckmedium beaufschlagbaren Druckring (3) hin und her bewegbar geführt ist, der zusammen mit dem Kolben (2) von einem Gehäuse (1) umschlossen wird, das eine Kammer (8) aufweist, in die das Druckmedium einbringbar ist, daß eine Druckfeder (4), deren Federkraft kleiner ist als die Druckkraft des einwirkenden Druckmediums, auf dem Kolben (2) geführt ist, die sich einerseits an einem ortsfesten Gehäuseteil und andererseits an der der Druckseite des Kolbens (2) gegenüber liegenden Seite des Druckrings (3) abstützt, und daß mittels eines Tasters (7) die Druckmediumzufuhr unterbrechbar ist.

2. Vorrichtung nach Anspruch 1, **dadurch gekennzeichnet, daß** der Kolben (2) ein Bündchen (2a) aufweist, das in Gebrauchsstellung des Kolbens (2) am Druckring (3) anliegt.

3. Vorrichtung nach Anspruch 1, **dadurch gekennzeichnet, daß** die Kammer (8) durch eine Führungsbuchse (5) verschlossen ist, in der der Kolben (2) längsverschiebbar gelagert ist.

4. Vorrichtung nach Anspruch 1 oder 3, **dadurch gekennzeichnet, daß** sich die Druckfeder (4) im Inneren der Führungsbuchse (5) abstützt.

5. Vorrichtung nach Anspruch 1, **dadurch gekennzeichnet, daß** der Kolben (2) auf seiner der Steckeraufnahme zugewandten Seite abgeschrägt ist.

6. Vorrichtung nach Anspruch 1, **dadurch gekennzeichnet, daß** der Kolben (2) verdrehsicher gehalten ist.

7. Vorrichtung nach einem oder mehreren der vorhergehenden Ansprüche 1-6, **dadurch gekennzeichnet, daß** der Druckring (3) gegenüber der Wandung der Kammer (8) durch einen Dichtring (3a) abgedichtet ist.

## Claims

1. Device for testing a plug-type connector provided with cables for locking and/or contacting defects, with a receiving part which has a plug-type connector receptacle adapted to the outer contour of a particular plug-type connector, in at least one side region of which receptacle there is provided an arresting means, which has an arresting pin which can be brought into an arresting position by pressure and is designed as a plunger (2) which can be acted on on one side by a pressure medium, **characterized in that** the plunger (2) is guided in such a way that it can move back and forth in a pressure ring (3) which can likewise be subjected to the pressure medium and, together with the plunger (2), is enclosed by a housing (1), which has a chamber (8) into which the pressure medium can be introduced, **in that** a compression spring (4), the spring force of which is less than the compressive force of the acting pressure medium, is guided on the plunger (2) and is supported on one side on a fixed housing part and on the other side on the side of the pressure ring (3) opposite from the pressure side of the plunger (2), and **in that** the pressure medium supply can be interrupted by means of a button (7).

2. Device according to Claim 1, **characterized in that** the plunger (2) has a small collar (2a), which in the operative position of the plunger (2) bears against the pressure ring (3).

3. Device according to Claim 1, **characterized in that** the chamber (8) is closed by a guiding bush (5), in which the plunger (2) is mounted in a longitudinally displaceable manner.

4. Device according to Claim 1 or 3, **characterized in that** the compression spring (4) is supported in the interior of the guiding bush (5).

5. Device according to Claim 1, **characterized in that** the plunger (2) is bevelled on its side facing the plug-type connector receptacle.

6. Device according to Claim 1, **characterized in that** the plunger (2) is held secure to prevent it twisting.

7. Device according to one or more of the preceding Claims 1-6, **characterized in that** the pressure ring (3) is sealed with respect to the wall of the chamber (8) by a sealing ring (3a).

## Revendications

1. Dispositif pour contrôler les défauts d'encliquetage et/ou de mise en contact d'un connecteur pourvu de câbles, comportant un élément récepteur qui contient un logement de connecteur adapté au contour extérieur d'un connecteur déterminé, dans lequel est prévu, au moins dans une zone latérale, un dispositif d'arrêt qui comporte une broche d'arrêt pouvant être amenée par pression en position d'arrêt et qui est réalisée sous la forme d'un piston (2) qui peut être soumis d'un côté à l'action d'un fluide sous pression, **caractérisé en ce que** le piston (2) est monté de manière déplaçable en sens alternés dans une bague de pression (3) qui peut également être soumise à l'action du fluide sous pression et qui est enfermée avec le piston (2) par un boîtier (1), lequel comporte une chambre (8) dans laquelle peut être introduit le fluide sous pression, **en ce qu'**un ressort de pression (4), dont la force de ressort est inférieure à la force de pression du fluide sous pression agissant, est guidé sur le piston (2), ce ressort prenant appui d'une part contre une partie de boîtier fixe et d'autre part contre le côté de la bague de pression (3) opposé au côté de pression du piston (2), et **en ce que** l'arrivée du fluide sous pression peut être interrompue au moyen d'un bouton-poussoir (7).

2. Dispositif selon la revendication 1, **caractérisé en ce que** le piston (2) comporte un petit épaulement (2a) qui, en position d'utilisation du piston (2), s'applique contre la bague de pression (3).

3. Dispositif selon la revendication 1, **caractérisé en ce que** la chambre (8) est fermée par une douille de guidage (5) dans laquelle le piston (2) est monté de manière à pouvoir coulisser longitudinalement.

4. Dispositif selon la revendication 1 ou 3, **caractérisé en ce que** le ressort de pression (4) prend appui à l'intérieur de la douille de guidage (5).

5. Dispositif selon la revendication 1, **caractérisé en ce que** le piston (2) est chanfreiné sur son côté tourné vers le logement de connecteur.

6. Dispositif selon la revendication 1, **caractérisé en ce que** le piston (2) est maintenu bloqué en rotation.

7. Dispositif selon l'une ou plusieurs des revendications 1 à 6 précédentes, **caractérisé en ce que** la bague de pression (3) est rendue étanche par rapport à la paroi de la chambre (8), au moyen d'une bague d'étanchéité (3a).
